# EUROPÄISCHE PATENTSCHRIFT

(11) **EP 1 700 349 B1**
(45) Veröffentlichungstag und Bekanntmachung des Hinweises auf die Patenterteilung: **01.11.2017**
(21) Anmeldenummer: 04802941.7
(22) Anmeldetag: 14.12.2004
(51) Int. Cl.: H01L 33/00, H01L 31/18, H01L 33/56

(54) **VERFAHREN ZUM HERSTELLEN EINER MEHRZAHL STRAHLUNGSEMITTIERENDER UND/ODER STRAHLUNGSEMPFANGENDER HALBLEITERBAUELEMENTE**
METHOD OF MANUFACTURING A PLURALITY OF RADIATION-EMITTING AND/OR RADIATION-RECEIVING SEMICONDUCTOR DEVICES
PROCEDE DE FABRICATION D'UNE PLURALITE DE COMPOSANTS SEMI-CONDUCTEURS EMETTEURS DE RAYONNEMENT ET/OU RECEPTEURS DE RAYONNEMENT

(30) Priorität: 30.12.2003 DE 10361801; 02.04.2004 DE 202004005228 U
(43) Veröffentlichungstag der Anmeldung: 13.09.2006
(73) Patentinhaber: OSRAM Opto Semiconductors GmbH, 93055 Regensburg (DE)
(72) Erfinder: BRUNNER, Herbert, 93161 Sinzing (DE); JÄGER, Harald, 93049 Regensburg (DE); SORG, Jörg Erich, 93053 Regensburg (DE)
(74) Vertreter: Epping - Hermann - Fischer
(86) Internationale Anmeldenummer: PCT/DE2004/002738
(87) Internationale Veröffentlichungsnummer: WO 2005/064696

(56) Entgegenhaltungen:
- EP-A- 1 249 873
- EP-A- 1 267 423
- WO-A2-2004/004017
- DE-A1- 10 214 119
- GB-A- 2 104 827
- JP-A- H08 264 841
- JP-A- H11 354 673
- US-A- 3 531 856
- US-A- 5 648 687
- PATENT ABSTRACTS OF JAPAN Bd. 1997, Nr. 04, 30. April 1997 (1997-04-30) & JP 08 335719 A (NICHIA CHEM IND LTD), 17. Dezember 1996 (1996-12-17)
- PATENT ABSTRACTS OF JAPAN Bd. 018, Nr. 144 (E-1521), 10. März 1994 (1994-03-10) & JP 05 327028 A (SHARP CORP), 10. Dezember 1993 (1993-12-10)
- PATENT ABSTRACTS OF JAPAN Bd. 016, Nr. 354 (E-1242), 30. Juli 1992 (1992-07-30) & JP 04 111366 A (KYOCERA CORP), 13. April 1992 (1992-04-13)
- PATENT ABSTRACTS OF JAPAN Bd. 2003, Nr. 06, 3. Juni 2003 (2003-06-03) & JP 2003 051618 A (ROHM CO LTD), 21. Februar 2003 (2003-02-21)
- PATENT ABSTRACTS OF JAPAN Bd. 008, Nr. 226 (E-272), 17. Oktober 1984 (1984-10-17) & JP 59 107584 A (CASIO KEISANKI KK), 21. Juni 1984 (1984-06-21)
- PATENT ABSTRACTS OF JAPAN Bd. 1997, Nr. 03, 31. März 1997 (1997-03-31) & JP 08 298345 A (SHICHIZUN DENSHI:KK), 12. November 1996 (1996-11-12)

## Beschreibung

Die Erfindung bezieht sich auf ein Verfahren zur Herstellung einer Mehrzahl stralungsemittierender und/oder strahlungsempfangender Halbleiterbauelemente gemäß dem unabhängigen Anspruch 1. Zur Erläuterung des Verfahrens ist im Folgenden ferner ein strahlungsemittierendes und/oder strahlungsempfangendes Halbleiterbauelement beschrieben.

Derartige Halbleiterbauelemente sind beispielsweise aus der WO 01/50540 bekannt. Bei dem dort beschriebenen Bauelement ist ein Halbleiterchip auf einem Leadframe montiert. Der Halbleiterchip und Teilbereiche des Leadframes sind mit einem spritzgepressten Kunststoff-Formkörper umhüllt. Externe elektrische Anschlüsse des Leadframes ragen aus dem Kunststoff-Formkörper heraus. Der Kunststoff-Formkörper ist beispielsweise aus einem Epoxidharz gefertigt und kann anorganischen oder organischen Konversionsstoff sowie Füllstoffe enthalten.

Eine andere Art von optoelektronischen Bauelementen ist beispielsweise in der WO 99/07023 beschrieben. Bei diesen ist ein Leadframe, auf dem sich der Halbleiterchip befindet, mit einem Gehäusegrundkörper umformt, der eine reflektorartige Ausnehmung aufweist. In der Ausnehmung ist der Halbleiterchip angeordnet. Die Ausnehmung wird nach der Montage des Halbleiterchips mit einer strahlungsdurchlässigen, oftmals transparenten Vergussmasse zumindest so weit gefüllt, dass der Halbleiterchip und ggf. ein Bonddraht vom Chip zum Leadframe mit dieser umhüllt sind. Eine bekannte Vergussmasse für solche Bauformen ist beispielsweise transparentes Epoxidgießharz. Ähnliche Bauformen sind beispielsweise aus der WO 98/12757 bekannt.

In der US 6,274,924 B1 ist eine oberflächenmontierbare LED-Gehäusebauform beschrieben, bei der ein starrer Kunststoffkörper, in dem der Halbleiterchip angeordnet und mit externen elektrischen Anschlüssen eines Leiterrahmens elektrisch verbunden ist, mit einem weichen strahlungsdurchlässigen Verkapselungsmaterial, beispielsweise mit Silikon, gefüllt ist. Auf den Kunststoffkörper ist eine Linsenkappe aufgesetzt. Diese Linsenkappe verleiht dem Verkapselungsmaterial einerseits eine definierte Form und verhindert andererseits dessen Herausfließen aus dem Gehäusegrundkörper. Aufgrund der vergleichsweise großen Zahl von Gehäusekomponenten erfordert diese LED-Gehäusebauform einen vergleichsweise großen Fertigungsaufwand.

Die Druckschrift JP 08-335719 A offenbart eine Leuchtdiode aus einem Nitrat-Halbleitermaterial, bei der ein Silikonharz in eine Vertiefung eines Leadframe eingefüllt wird und der Leadframe dann mit einem Epoxidharz umformt wird.

Die Druckschrift EP 1 267 423 A2 offenbart einen Verguss für eine lichtemittiernde Vorrichtung aus einem Silikon-Gummi, der eine Epoxidgruppe enthält und in eine Vertiefung eines Gehäuses eingefüllt wird.

Die Druckschrift EP 1 249 873 A2 offenbart ein lichtemittierendes Bauelement mit einem lichtemittierenden Element, das in einem Silikonharz eingebettet ist.

Die Druckschriften US 3,531,856, JP H08264841 A, JP H11354673 A und WO 2004/004017 A2 offenbaren jeweils ein strahlungsemittierendes und/oder strahlungsempfangendes Halbleiterbauelement und/oder ein Verfahren zur Herstellung eines strahlungsemittierenden und/oder strahlungsempfangenden Halbleiterbauelements.

Die Druckschrift GB 2 104 827 A beschreibt ein Verfahren zur Herstellung einer elektronischen Komponente.

Der vorliegenden Erfindung liegt die Aufgabe zu Grunde, ein Halbleiterbauelement der eingangs genannten Art derart weiterzubilden, dass es einerseits technisch einfach herstellbar und andererseits insbesondere bei Einsatz von blaues Licht oder UV-Strahlung emittierenden Halbleiterchips hinreichend alterungsstabil ist.

Diese Aufgabe wird durch ein Verfahren mit den Merkmalen des unabhängigen Patentanspruchs gelöst. Vorteilhafte Weiterbildungen des Verfahrens sind in den jeweils abhängigen Ansprüchen angegeben.

Ein hier beschriebenes strahlungsemittierendes und/oder strahlungsempfangendes Halbleiterbauelement umfasst folgende Bestandteile:
- einen strahlungsemittierenden und/oder strahlungsempfangenden Halbleiterchip,
- ein insbesondere spritzgegossenes oder spritzgepresstes Kunststoff-Formteil, das für eine vom Halbleiterbauelement zu emittierende und/oder zu empfangende elektromagnetische Strahlung durchlässig ist, mit dem der Halbleiterchip zumindest teilweise umformt ist und das aus einer reaktionshärtenden Silikon-Formmasse besteht, und
- externe elektrische Anschlüsse, die mit elektrischen Kontaktflächen des Halbleiterchips elektrisch verbunden sind.

Unter den Begriff Silikon-Formmasse fallen vorliegend nicht nur Formmassen, die ausschließlich aus Silikon bestehen, sondern auch solche mittels eines Mold-Prozesses zu Kunststoff-Formteilen verarbeitbare Formmassen, die zu einem solchen Anteil aus Silikon bestehen, dass die Alterungsstabilität der Formmasse gegenüber herkömmlichen Formmassen hinreichend verbessert ist.

Die Silikon-Formmasse weist vorzugsweise eine Aushärtezeit von gleich oder weniger als 10 Minuten auf. Dies erleichtert vorteilhafterweise die Herstellung der Halbleiterbauelemente unter Realisierung von wirtschaftlich sinnvollen Maschinentaktzeiten.

Die Silikon-Formmasse weist im ausgehärteten Zustand bevorzugt eine Härte von gleich oder größer als 65 Shore D auf.

Dadurch wird vorteilhafterweise die Formstabilität des Kunststoff-Formteils gegenüber mechanischen Einflüssen verbessert.

Weiterhin ist die Formmasse bevorzugt ein Silikon-Composite-Material, das neben Silikon mindestens ein weiteres Material umfasst, wie beispielsweise ein Epoxidharz. Solche Composite-Materialien bieten den Vorteil, dass sie an die Anforderungen der jeweiligen Anwendung und der verwendeten Prozesse angepasst werden können. Silikon-Epoxidharz-Composite härten beispielsweise in der Regel schneller aus als reine Silikonformmassen und besitzen eine höhere mechanische Festigkeit. Aus diesem Grund lassen sie sich meist leichter entformen und es sind kürzere Prozesszeiten möglich.

Zur Herstellung von Mischlicht emittierenden Halbleiterbauelementen enthält die Silikon-Formmasse Konvertermaterial, das zumindest einen Teil einer vom Halbleiterchip emittierten und/oder vom Halbleiterbauelement empfangenen elektromagnetischen Strahlung eines ersten Wellenlängenbereichs absorbiert und elektromagnetische Strahlung emittiert, die aus einem zweiten Wellenlängenbereich stammt, der vom ersten Wellenlängenbereich verschieden ist. Insbesondere anorganische Leuchtstoffpulver lassen sich auf einfache Weise in SilikonMaterial einmischen. Beispielhaft seien diesbezüglich Cer-dotierte Yttriumaluminiumgranat- und Cer-dotierte Terbiumaluminiumgranat-Pulver genannt. Andere geeignete anorganische Leuchtstoffe sind beispielsweise in den Druckschriften WO 01/50540 A1 und WO 98/12757 A1 aufgeführt, deren Offenbarungsgehalt insofern hiermit durch Rückbezug aufgenommen wird.

Bevorzugt wird ein Kunststoff-Formteil gemäß der Erfindung bei Halbleiterbauelementen eingesetzt, die einen Halbleiterchip aufweisen, der elektromagnetische Strahlung aus dem blauen oder ultravioletten Spektralbereich emittiert.

Bei einer bevorzugten Ausführungsform ist der Halbleiterchip von einem einzigen einstückigen Kunststoff-Formteil aus reaktionshärtender Silikon-Formmasse umformt. Ein Grundprinzip eines derartigen Kunststoff-Formteils ist beispielsweise in der Druckschrift WO 01/50540 beschrieben, deren Offenbarungsgehalt insofern hiermit durch Rückbezug aufgenommen wird.

Bei einer anderen bevorzugten Ausführungsform ist der Halbleiterchip auf einem Trägersubstrat oder einer Trägerfolie mit elektrischen Leiterbahnen zum elektrischen Anschließen des Halbleiterchips aufgebracht und der Halbleiterchip mit einem Kunststoff-Formteil aus reaktionshärtender Silikon-Vergussmasse eingekapselt.

Bei einem bevorzugten Verfahren zum Herstellen eines Halbleiterbauelements gemäß der Erfindung wird der Halbleiterchip auf einem Leiterrahmen befestigt, der die externen elektrischen Anschlüsse aufweist, und mit den externen elektrischen Anschlüssen elektrisch verbunden. Nachfolgend wird der Halbleiterchip einschließlich Teilbereiche des Leiterrahmens mittels eines Spritzgußverfahrens oder mittels eines Spritzpressverfahrens mit einer Silikon-Formmasse umformt.

Bei einem anderen bevorzugten Verfahren wird ein Halbleiterchip auf einem Trägersubstrat oder einer Trägerfolie mit elektrischen Leiterbahnen zum elektrischen Anschließen des Halbleiterchips aufgebracht und mit den elektrischen Leiterbahnen elektrisch verbunden. Nachfolgend wird der Halbleiterchip auf dem Trägersubstrat bzw. der Trägerfolie mittels eines Spritzgußverfahrens oder mittels eines Spritzpressverfahrens mit einer Silikon-Formmasse verkapselt.

Besonders bevorzugt findet die Erfindung Verwendung bei strahlungsemittierenden und/oder strahlungsempfangenden Halbleiterbauelementen mit einer Stellfläche (footprint) von etwa 0,5 mm x 1,0 mm oder weniger und/oder mit einer gesamten Bauteilhöhe von lediglich 350 *µ*m oder weniger, vorzugsweise 250 *µ*m oder weniger.

Weitere Vorteile, Weiterbildungen und vorteilhafte Ausführungsformen ergeben sich aus den im Folgenden in Verbindung mit den Figuren 1 bis 3 erläuterten Ausführungsbeispielen. Es zeigen:
Figur 1, eine schematische Darstellung eines Schnittes durch ein ersten Ausführungsbeispiel,
Figur 2, eine schematische Darstellung eines Schnittes durch ein zweites Ausführungsbeispiel, und
Figur 3, eine schematische Darstellung eines Schnittes durch ein drittes Ausführungsbeispiel.

In den verschiedenen Ausführungsbeispielen sind gleiche oder gleichwirkende Bestandteile jeweils gleich bezeichnet und mit den gleichen Bezugszeichen versehen. Die Figuren sind grundsätzlich nicht als maßstabsgerecht anzusehen. Die einzelnen Bestandteile sind grundsätzlich auch nicht mit den tatsächlichen Größenverhältnissen zueinander dargestellt.

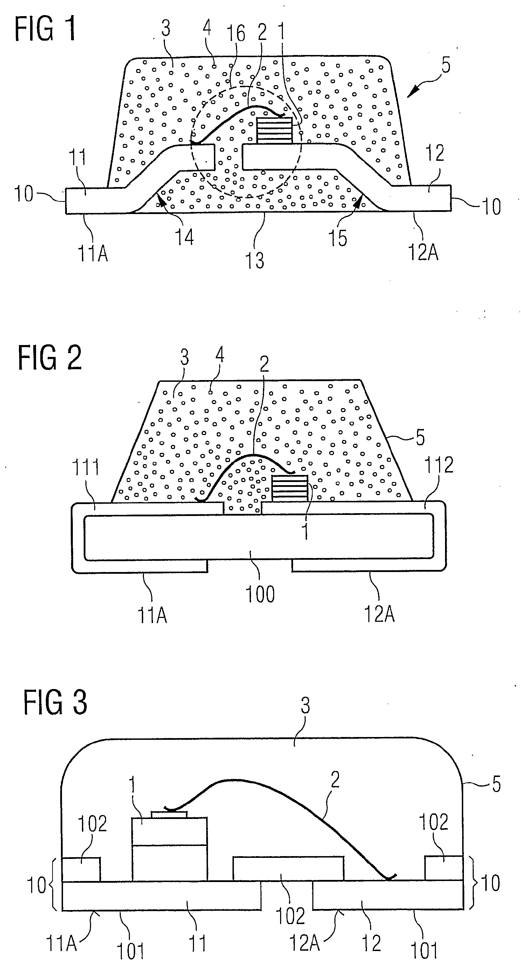

Beim ersten Ausführungsbeispiel gemäß Figur 1 handelt es sich um ein weißes Licht emittierendes Leuchtdiodenbauelement auf Leiterrahmen(Leadframe)-Basis.

Ein metallischer Leiterrahmen (Leadframe) 10, auf dem in einem Chipmontagebereich 16 ein LED-Chip 1 montiert ist, ist mit einer transparenten Silikon-Formmasse 3 umformt, aus der an zwei gegenüberliegenden Seitenflächen je ein Leadframeanschluß 11,12 herausragt. Die Leadframe-Anschlüsse 11,12 stellen die externen elektrischen Anschlüsse des Leuchtdiodenbauelements dar. Innerhalb der transparenten Silikon-Formmasse 3 weist jeder der Leadframeanschlüsse 11,12 eine S-artige Biegung 14,15 von einem Chipmontagebereich 16 zu einer Montageseite 13 des Leuchtdiodenbauelements hin auf.

Der Silikon-Formmasse 3 kann zur Erhöhung des Brechungsindex mindestens ein anorganischer Füllstoff wie TiO₂, ZrO₂ oder α-Al₂O₃ beigemengt sein.

Bei dem Verfahren zur Herstellung einer Leuchtdioden-Lichtquelle gemäß der Figur 1 wird der LED-Chip 1 im Chipmontagebereich 16 auf dem Leadframe 10 montiert und mit den Leadframeanschlüssen 11,12 elektrisch leitend verbunden. Die Leadframeanschlüsse 11,12 werden vor oder nach dem Montieren des Halbleiter-LED-Chips 1 mit S-artigen Biegungen 14,15 versehen. Der Halbleiter-LED-Chip 1 einschließlich der S-artigen Biegungen 14,15 des Leadframes 10 werden mittels eines Spritzpress- oder Spritzgussverfahrens mit einer transparenten Silikon-Formmasse 3 umformt. Die Silikon-Formmasse 3 wird dann noch in der Spritzpress- oder Spritzgussform zumindest teilweise gehärtet, so dass ein hinreichend formstabiles einstückiges Kunststoff-Formteil 5 gebildet wird.

Bei einer Weißlichtquelle weist der Halbleiter-LED-Chip 1 ein Emissionsspektrum auf, das im ultravioletten oder blauen Spektralbereich liegt. Vorzugsweise ist der Halbleiter-LED-Chip 1 auf der Basis von GaN oder InGaN aufgebaut. Er kann jedoch alternativ auch aus dem Materialsystem ZnS/ZnSe oder aus einem anderen für diesen Spektralbereich geeigneten Materialsystem bestehen.

Nach dem Aufbringen und Kontaktieren des Halbleiter-LED-Chips 1 wird in einer geeigneten Spritzguss- oder Spritzpressapparatur eine transparente Silikon-Formmasse 3 an die Leadframeanschlüsse 11 und 12 angespritzt. In die Silikon-Formmasse 3 sind Leuchtstoffpartikel 4 eingebettet, die aus einem Konversionsstoff bestehen, mit dem eine mindestens teilweise Wellenlängenkonversion der von dem Halbleiter-LED-Chip 1 emittierten elektromagnetischen Strahlung herbeigeführt wird. Mittels dieser Wellenlängenkonversion wird ein Emissionsspektrum erzeugt, das den optischen Eindruck einer Weißlichtquelle hervorruft. Ein geeigneter Leuchtstoff für die Leuchtstoffpartikel ist beispielsweise Cer-dotiertes Yttriumaluminiumgranat- und Cer-dotiertes Terbiumaluminiumgranat-Pulver.

Die Vorfertigung des Leadframes 10 und die Umformung mit der Silikon-Formmasse 3, die gegebenenfalls die Leuchtstoffpartikel 4 und gegebenenfalls weitere Füllstoffe enthält erfolgt derart, dass die Leadframeabschnitte 11 und 12 horizontal aus dem Kunststoff-Formteil 5 herausgeführt sind, und zwar derart, dass deren Löt-Anschlussflächen 11A und 12A im Wesentlichen in derselben Ebene liegen wie die Rückseite des Kunststoff-Formteiles 5, die in der Regel die Auflagefläche des Bauelements auf einer Leiterplatte darstellt. Die Leadframeanschlüsse 11 und 12 sind hierzu vor dem Vergießen bereits in die endgültige Form gebogen. Sie weisen also die S-artigen Biegungen vom Chipanschlußbereich zur Montagefläche hin bereits vor dem Umformen auf, so dass nach dem Umformen kein Biegestress mehr auf das Bauelement ausgeübt wird. Dies ist insbesondere bei stark miniaturisierten Bauelementen mit kleinvolumigem Kunststoff-Formteil 5 von besonderem Vorteil, denn gerade hier besteht bei einer Delamination zwischen Verguss und Leadframe, ausgelöst beispielsweise durch Biegestress, eine sehr große Gefahr, dass keine hermetische Dichtigkeit des fertigen Bauteils erreicht wird.

Die Silikon-Formmasse 3 weist beispielsweise eine Aushärtezeit von gleich oder weniger als 10 Minuten und im ausgehärteten Zustand eine Härte von gleich oder größer als 65 Shore D auf.

Das fertige Bauelement kann vorteilhafterweise an den ebenen horizontalen Anschlussflächen 11A und 12A auf einer Leiterplatte (Platine) im Reflow-Verfahren aufgelötet werden. Dadurch wird ein für die SMT-(Surface Mounting Technology) Montage geeignetes Bauelement hergestellt.

Auf gleiche Weise kann ein UV- oder blaue Strahlung detektierendes Photodioden-Bauelement ausgebildet werden.

Das zweite Ausführungsbeispiel gemäß Figur 2 unterscheidet sich von dem ersten Ausführungsbeispiel gemäß Figur 1 insbesondere dadurch, dass an Stelle des Leiterrahmens 10 ein elektrisch isolierendes Trägersubstrat 100 mit elektrischen Leiterbahnen 111,112 in Form von Metallisierungsschichten vorgesehen ist. Das Kunststoff-Formteil 5 befindet sich auf dem Trägersubstrat 100. Dieses Bauelement kann in analoger Weise wie das erste Ausführungsbeispiel hergestellt werden.

Das dritte Ausführungsbeispiel gemäß Figur 3 ist eine Miniatur-Lumineszenzdiode, die einen flexiblen Leiterrahmen 10, einen LED-Chip 1 mit einem aktiven, strahlungsemittierenden Bereich und einen Kunststoff-Formteil 5 aufweist. Der flexible Leiterrahmen 10 besteht dabei aus einer 60 µm dicken Metallfolie 101 und einer ebenfalls 60 µm dicken Kunststoff-Folie 102, die hochgenau miteinander verklebt sind. Die Kunststoff-Folie kann aus einem Silikon-Kunststoff bestehen.

Die Metallfolie 101 ist so gestanzt, dass sie eine Kathode und eine Anode definiert. Jeweils über Kathode und Anode sind Aussparungen in die Kunststoff-Folie 102 gestanzt. Der LED-Chip 1 ist mit seiner Unterseite durch eine der Aussparungen hindurch auf die Kathode gebondet. Die Anode ist über einen Bonddraht 2 durch die andere Aussparung mit der Oberseite des LED-Chips 1 verbunden.

Um auf dem flexiblen Rahmen möglichst viele Bauteile realisieren zu können, wird zum Umhüllen beispielsweise das sogenannte Cavity-to-Cavity Molding eingesetzt, mit dem über jedem flexiblen Leiterrahmen 10 ein Kunststoff-Formteil 5 hergestellt wird, das den LED-Chip 1 und den Bonddraht 2 umhüllt. Durch die Führung eines Anspritzkanals durch die Bauteile wird die Anzahl der Anspritzkanäle reduziert. Das Kunststoff-Formteil besteht aus dem gleichen Material wie das Kunststoff-Formteil der vorgenannten Ausführungsbeispiele. Weiterhin können die Bauteile auch mit einem Array-Molding-Verfahren umhüllt werden. Beim Array-Molding werden Kavitäten des Werkzeuges gefüllt, die jeweils mehrere Bauteile umfassen. Die umspritzen Bauteile werden nach dem Erkalten der Formteile getrennt, beispielsweise durch Sägen. Die Flächendichte ist beim Array-Molding in der Regel vorteilhafterweise größer als beim Cavity-to-Cavity-Molding.

Insgesamt hat die Miniatur-Lumineszenzdiode eine Stellfläche (footprint) von etwa 0,5 mm x 1,0 mm und weist eine gesamte Bauteilhöhe von lediglich 250*µ*m auf.

An Stelle des Lumineszenzdiodenchips kann ein Photodiodenchip eingesetzt sein oder ein Chip der als Lumineszenzdiode und als PhotoDiode betrieben wird.

## Patentansprüche

1. Verfahren zum Herstellen einer Mehrzahl strahlungsemittierender und/oder strahlungsempfangender Halbleiterbauelemente jeweils aufweisend
- einen strahlungsemittierenden und/oder strahlungsempfangenden Halbleiterchip (1),
- ein Kunststoff-Formteil (5), das für eine vom Halbleiterbauelement zu emittierende und/oder zu empfangende elektromagnetische Strahlung durchlässig ist, aus einer reaktionshärtenden Silikon-Formmasse (3) besteht und mit dem der Halbleiterchip (1) zumindest teilweise umformt ist, und
- externe elektrische Anschlüssen (11, 111, 12, 112), die mit elektrischen Kontaktflächen des Halbleiterchips elektrisch verbunden sind,
**dadurch gekennzeichnet, dass**
- jeder Halbleiterchip (1) auf einem metallischen Leiterrahmen (10), einem Trägersubstrat (100) oder einer Trägerfolie (10) befestigt wird, der/die die externen elektrischen Anschlüsse (11, 111, 12, 112) aufweist,
- jeder Halbleiterchip (1) einschließlich Teilbereiche des Leiterrahmens (10), des Trägersubstrats (100) oder der Trägerfolie (10) in eine Kavität einer Spritzform eingebracht wird,
- die Silikon-Formmasse (3) mittels eines Spritzgußverfahrens oder mittels eines Spritzpressverfahrens in die Kavität eingespritzt wird, und
- die Silikon-Formmasse (3) in der Kavität zumindest teilweise gehärtet wird, sodass das formstabile Kunststoff-Formteil (5) gebildet wird.

2. Verfahren nach dem vorherigen Anspruch,
wobei die Silikon-Formmasse (3) eine Aushärtezeit von gleich oder weniger als 10 Minuten aufweist.

3. Verfahren nach einem der beiden vorherigen Ansprüche, wobei die Silikon-Formmasse (3) im ausgehärteten Zustand eine Härte von gleich oder größer als 65 Shore D aufweist.

4. Verfahren nach einem der vorherigen Ansprüche,
wobei die Silikon-Formmasse (3) ein Silikon-Composite-Material ist.

5. Verfahren nach einem der vorherigen Ansprüche,
wobei die Halbleiterbauelemente nach dem Erkalten der Kunststoff-Formteile (5) getrennt werden.

6. Verfahren nach einem der vorherigen Ansprüche,
wobei das Kunststoff-Formteil (5) mittels Cavity-to-Cavity Molding oder Array-Molding hergestellt wird.

7. Verfahren nach einem der vorherigen Ansprüche,
wobei der Halbleiterchip (1) auf den Leiterrahmen (10) montiert wird und die externen elektrischen Anschlüsse (11, 12) vor oder nach dem Montieren des Halbleiterchips (1) mit S-artigen Biegungen versehen werden.

## Claims

1. Method for producing a plurality of radiation-emitting and/or radiation-receiving semiconductor devices each comprising
- a radiation-emitting and/or radiation-receiving semiconductor chip (1),
- a plastics molded part (5), which is transmissive to electromagnetic radiation to be emitted and/or received by the semiconductor device, consists of a reaction-curing silicone molding composition (3) and with which the semiconductor chip (1) is at least partly encapsulated,
and
- external electrical terminals (11, 111, 12, 112), which are electrically connected to electrical contact faces of the semiconductor chip,
**characterized in that**
- each semiconductor chip (1) is fastened to a metallic leadframe (10), a carrier substrate (100) or a carrier foil (10), which comprises the external electrical terminals (11, 111, 12, 112),
- each semiconductor chip (1), including sub-regions of the leadframe (10), of the carrier substrate (100) or of the carrier foil (10), is introduced into a cavity of an injection mold,
- the silicone molding composition (3) is injected into the cavity using an injection molding method or a transfer molding method, and
- the silicone molding composition (3) is at least partly cured in the cavity, such that the dimensionally stable plastics molded part (5) is formed.

2. Method according to the preceding claim,
wherein the silicone molding composition (3) has a curing time of less than or equal to 10 minutes.

3. Method according to one of the two preceding claims, wherein, in the cured state, the silicone molding composition (3) has a hardness greater than or equal to 65 Shore D.

4. Method according to one of the preceding claims, wherein the silicone molding composition (3) is a silicone composite material.

5. Method according to one of the preceding claims, wherein the semiconductor devices are diced once the plastics molded parts (5) have cooled.

6. Method according to one of the preceding claims, wherein the plastics molded part (5) is produced by cavity-to-cavity molding or array molding.

7. Method according to one of the preceding claims, wherein the semiconductor chip (1) is mounted on the leadframe (10) and the external electrical terminals (11, 12) are provided with S-type bends before or after mounting of the semiconductor chip (1).

## Revendications

1. Procédé de fabrication d'une pluralité de dispositifs semi-conducteurs émettant un rayonnement et/ou recevant un rayonnement, présentant respectivement
- une puce à semi-conducteur (1) émettant un rayonnement et/ou recevant un rayonnement,
- une pièce moulée (5) en matière plastique, qui est perméable à un rayonnement électromagnétique à émettre et/ou à recevoir par le dispositif semi-conducteur, qui est constituée d'une matière à mouler en silicone (3) durcissant par réaction et est formée au moins en partie avec la puce à semi-conducteur (1),
et
- des raccordements électriques externes (11, 111, 12, 112), qui sont reliés électriquement à des surfaces de contact électriques de la puce à semi-conducteur,
**caractérisé en ce que**
- chaque puce à semi-conducteur (1) est fixée sur un cadre conducteur (10), un substrat porteur (100) ou un film porteur (10) qui présente les raccordements électriques externes (11, 111, 12, 112),
- chaque puce à semi-conducteur (1), y compris des zones partielles du cadre conducteur (10), du substrat porteur (100) ou du film porteur (10), est placée dans une cavité d'un moule d'injection,
- la matière à mouler en silicone (3) est injectée dans la cavité au moyen d'un procédé de moulage par injection ou au moyen d'un procédé de moulage par transfert, et
- la matière à mouler en silicone (3) est durcie au moins en partie dans la cavité de sorte que la pièce moulée (5) en matière plastique, de forme stable, est formée.

2. Procédé selon la revendication précédente,
la matière à mouler en silicone (3) présentant un temps de durcissement égal ou inférieur à 10 minutes.

3. Procédé selon l'une quelconque des deux revendications précédentes, la matière à mouler en silicone (3) présentant à l'état durci une dureté égale ou supérieure à 65 Shore D.

4. Procédé selon l'une quelconque des revendications précédentes, la matière à mouler en silicone (3) étant une matière composite en silicone.

5. Procédé selon l'une quelconque des revendications précédentes, les dispositifs semi-conducteurs étant séparés après le refroidissement des pièces moulées (5) en matière plastique.

6. Procédé selon l'une quelconque des revendications précédentes, la pièce moulée (5) en matière plastique étant fabriquée par moulage Cavity-to-Cavity Molding ou Array-Molding.

7. Procédé selon l'une quelconque des revendications précédentes,
la puce à semi-conducteur (1) étant montée sur le cadre conducteur (10) et les raccordements électriques externes (11, 12) étant munis de courbures en S avant ou après le montage de la puce à semi-conducteur (1).
